# EUROPEAN PATENT APPLICATION

(11) **EP 4 336 260 A2**
(43) Date of publication of application: **13.03.2024**
(21) Application number: 23192564.5
(22) Date of filing: 22.08.2023
(51) Int. Cl.: G03F 7/00

(54) **STAGE APPARATUS, PATTERN FORMING APPARATUS, AND METHOD FOR MANUFACTURING ARTICLE**

(30) Priority: 12.09.2022 JP 2022144371
(71) Applicant: CANON KABUSHIKI KAISHA, Tokyo 146-8501 (JP)
(72) Inventor: OZAWA, Yuichi, Tokyo (JP)
(74) Representative: WESER & Kollegen Patentanwälte PartmbB

(57) **Abstract**

The stage apparatus according to the present invention includes a first stage configured to be movable in a first direction, a first driving unit configured to generate a thrust force to move the first stage in the first direction, and a reaction force reducing unit configured to generate a thrust force to reduce a reaction force generated by the generation of the thrust force of the first driving unit. The reaction force reducing unit can generate the thrust forces with different magnitudes from each other at a plurality of positions in a second direction perpendicular to the first direction, and can generate the thrust forces with different magnitudes from each other at a plurality of positions in a third direction perpendicular to the first direction and the second direction.

## Description

### BACKGROUND OF THE INVENTION

### Field of the Invention

The present invention is related to a stage apparatus, a pattern forming apparatus, and a method for manufacturing an article.

### Description of the Related Art

Conventionally, it is known that a reaction force generated by applying a thrust force to a stage in order to move the stage in a predetermined direction becomes a disturbance in a stage apparatus, which may make an operation of the stage apparatus unstable.

Japanese Patent Application Laid-Open No. H11-168064 discloses a stage apparatus including a thrust force generating unit that generates a thrust force for canceling out a reaction force generated when a stage is moved in a predetermined direction.

The thrust force generating unit provided in the stage apparatus disclosed in Japanese Patent Application Laid-Open No. H11-168064 generates the thrust force for canceling out the reaction force at a single position.

Accordingly, when a position at which a thrust force is applied to the stage in order to move the stage in a predetermined direction, namely a position at which the reaction force is generated, and that at which a thrust force for canceling out the reaction force is generated are shifted from each other, a couple is generated, and the couple becomes a disturbance in the stage apparatus.

Although it is possible to suppress an occurrence of such couple by aligning both of the positions when the stage apparatus is assembled, a lot of time is required for such operation, so that the assembly may be delayed.

Further, even after the stage apparatus is assembled in such a manner, the couple may be generated by changing both of the above-described positions due to a change over time in a weight of a workpiece mounted on the stage apparatus, an assembly on the stage apparatus, a position and a posture of a structure and the like.

### SUMMARY OF THE INVENTION

An object of the present invention is to provide a stage apparatus capable of reducing a reaction force generated when a stage is moved with suppressing a generation of a couple.

The stage apparatus according to the present invention includes a first stage configured to be movable in a first direction, a first driving unit configured to generate a thrust force to move the first stage in the first direction, and a reaction force reducing unit configured to generate a thrust force to reduce a reaction force generated by the generation of the thrust force of the first driving unit. The reaction force reducing unit can generate the thrust forces with different magnitudes from each other at a plurality of positions in a second direction perpendicular to the first direction, and can generate the thrust forces with different magnitudes from each other at a plurality of positions in a third direction perpendicular to the first direction and the second direction.

Further features of the present invention will become apparent from the following description of exemplary embodiments with reference to the attached drawings.

### BRIEF DESCRIPTION OF THE DRAWINGS

FIG. 1A is a schematic sectional view of a stage apparatus according to a first embodiment of the present invention.
FIG. 1B is a schematic top view of the stage apparatus according to the first embodiment.
FIG. 2A is a schematic sectional view of a reaction force receiving mechanism provided in the stage apparatus according to the first embodiment.
FIG. 2B is a schematic top view of the reaction force receiving mechanism provided in the stage apparatus according to the first embodiment.
FIG. 3A is a schematic sectional view of a reaction force receiving mechanism provided in the stage apparatus according to a second embodiment of the present invention.
FIG. 3B is a schematic top view of the reaction force receiving mechanism provided in the stage apparatus according to the second embodiment.
FIG. 4 is a schematic sectional view of an exposure apparatus including the stage apparatus according to the present invention.

### DESCRIPTION OF THE EMBODIMENTS

A stage apparatus according to the present invention is described in detail below with reference to the accompanying drawings. Note that the drawings described below may be drawn on a scale different from the actual scale in order to facilitate understanding of the present invention.

Hereinafter, a vertical direction is defined as a Z direction (a third direction), and two directions orthogonal to each other in a plane perpendicular to the Z direction are defined as an X direction (a first direction) and a Y direction (a second direction). Rotation axes around the X axis, the Y axis and the Z axis are defined as an ωX axis, an ωY axis and an ωZ axis, respectively.

### [First Embodiment]

Conventionally, there is known a stage apparatus including a first stage that moves in a first direction perpendicular to a vertical direction, and a second stage that moves in a second direction perpendicular to the vertical direction and the first direction.

The stage apparatus is configured such that the first stage is coupled to the second stage, thereby the first stage also moves in the second direction in accordance with a movement of the second stage in the second direction, namely in conjunction with the second stage.

In such stage apparatus, it is required to cancel out a reaction force generated when the first stage moves in the first direction, for example.

Accordingly, there has been proposed a conventional stage apparatus in which a thrust force generation unit that generates a thrust force for canceling out the reaction force generated when the first stage moves in the first direction is provided in the second stage.

With this structure, even when the first stage is arranged at various positions in the second direction, the reaction force can be canceled out in the stage apparatus.

In such stage apparatus, a couple is generated in a case that a position at which a reaction force is generated when the first stage moves in the first direction and a position at which a thrust force for canceling out the reaction force is generated by the thrust force generation unit provided in the second stage are shifted from each other.

In other words, the couple is generated in a case that the position at which a driving thrust force acts on the first stage to move the first stage in the first direction and the position at which the thrust force for canceling out the reaction force is generated by the thrust force generation unit provided in the second stage are shifted from each other.

Then, since the couple thus generated is input (applied) to the stage apparatus as a disturbance, a precise operation in the stage apparatus is disturbed.

In the above-described stage apparatus, the thrust force generating unit provided in the second stage generates the thrust force for canceling out the reaction force at a single position, namely a uniaxial thrust force.

Accordingly, a couple is generated unless a position at which the reaction force is generated when the first stage moves in the first direction and a position at which a thrust force for canceling out the reaction force is generated by the thrust force generation unit provided in the second stage are aligned with each other when the stage apparatus is assembled.

Then, since a lot of time is required for an operation for aligning both of the above-described positions in the assembly of the stage apparatus, there is a concern that the assembly is delayed.

Further, even after the stage apparatus is assembled in such a manner, there is a possibility that the couple is generated by changing both of the above-described positions due to a change over time in a weight of a workpiece mounted on the stage apparatus, an assembly on the stage apparatus, a position and posture of a structure and the like.

Accordingly, an object of the present invention is to provide a stage apparatus capable of canceling out the reaction force generated when moving the stage with suppressing the generation of the couple.

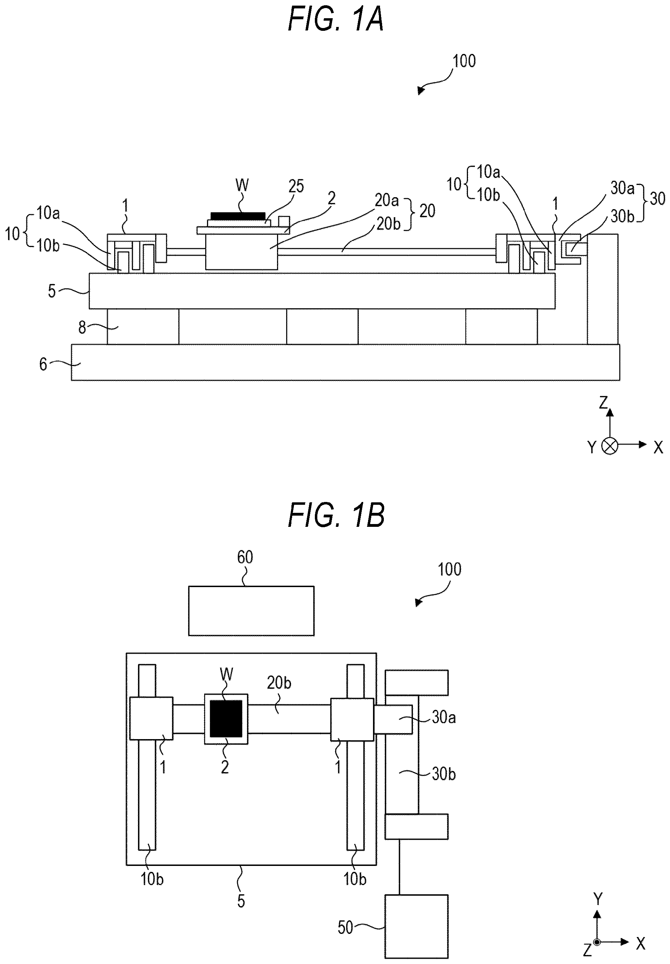

FIGS. 1A and 1B show a schematic sectional view and a schematic top view of a stage apparatus 100 according to a first embodiment of the present invention, respectively.

The stage apparatus 100 according to the present embodiment includes a Y stage 1 (a second stage), an X stage 2 (a first stage), a platen 5, a base frame 6 and a vibration isolation base 8.

Further, the stage apparatus 100 according to the present embodiment includes a Y linear motor 10 (a second driving unit), an X linear motor 20 (a first driving unit), a reaction force receiving mechanism 30 (a reaction force reducing unit), a controller 50 and a measuring unit 60.

As shown in FIGS. 1A and 1B, the Y stage 1 and the Y linear motor 10 are provided on both sides in the X direction of the X stage 2 in the stage apparatus 100 according to the present embodiment.

The two Y stages 1 are coupled (fixed) to each other by an X linear motor stator 20b of the X linear motor 20, and can be moved in the Y direction by the Y linear motor 10.

Here, the two Y stages 1 and the X linear motor stator 20b can be collectively referred to as a Y stage.

The X stage 2 can be moved in the X direction by the X linear motor 20.

Further, the X stage 2 has a fine movement top plate 25, and the fine movement top plate 25 holds a substrate W and can finely drive a holding surface for holding the substrate W.

Specifically, the holding surface for holding the substrate W can be driven not only in the Z axis and the ωZ axis but also in the ωX axis and the ωY axis by providing three Z linear motors and one ωZ linear motor (not shown) in the fine movement top plate 25.

Thereby, the holding surface for holding the substrate W can be driven in all of six axes of the X axis, the Y axis, the Z axis, the ωX axis, the ωY axis and the ωZ axis in the stage apparatus 100 according to the present embodiment.

The vibration isolation base 8 is a vibration isolation mechanism formed by an air spring or a coil spring, and is supported by the base frame 6.

Then, the vibration isolation base 8 is configured to suppress a propagation of vibration from the outside to the stage apparatus 100 according to the present embodiment, and to control a position and posture of the platen 5.

The Y linear motor 10 includes a Y linear motor movable element 10a (a second movable element) which is a movable portion, and a Y linear motor stator 10b (a second stator), which is a fixed portion extending in the Y direction through an opening portion of the Y linear motor movable element 10a.

Then, the Y linear motor 10 acts as a driving unit that generates a thrust force to move the Y stage 1 in the Y direction.

Specifically, the Y linear motor movable element 10a is a U-shaped frame body formed by an aluminum plate that holds multipolar magnets (permanent magnets) (not shown) facing each other, and is configured to be movable in the Y direction with respect to the Y linear motor stator 10b.

On the other hand, the Y linear motor stator 10b has a coil array arranged in the Y direction, and is fixed to a floor (not shown).

That is, the Y linear motor 10 has a moving magnet structure.

By sequentially switching an orientation of a current supplied to each coil of the coil array of the Y linear motor stator 10b, a thrust force in the Y direction is generated in the Y linear motor movable element 10a.

The thrust force generated in this manner moves the X linear motor 20 connected to the Y stage 1 and the X stage 2 in the Y direction together with the Y stage 1.

The X linear motor 20 includes an X linear motor stator 20b (a first stator) which is a fixed portion extending in the X direction, and an X linear motor movable element 20a (a first movable element) which is a movable portion movable in the X direction with respect to the X linear motor stator 20b.

Then, the X linear motor 20 acts as a driving unit that generates a thrust force to move the X stage 2 in the X direction.

Specifically, the X linear motor movable element 20a is a hollow frame body, holds multipolar magnets (permanent magnets) (not shown) facing each other on an upper surface and a lower surface in the vertical direction of an inner surface, and is configured to be movable in the X direction with respect to the X linear motor stator 20b.

On the other hand, the X linear motor stator 20b has a coil array arranged in the X direction, and is fixed to the Y stage 1 and the Y linear motor movable element 10a.

That is, the X linear motor 20 has a moving magnet structure.

By sequentially switching an orientation of a current supplied to each coil of the coil array of the X linear motor stator 20b, a thrust force in the X direction is generated in the X linear motor movable element 20a to move the X stage 2 in the X direction by the generated thrust force.

As described above, the X linear motor 20 and the X stage 2 are configured to move in the Y direction in accordance with the movement in the Y direction of the Y stage 1, namely to move in conjunction with the Y stage 1.

The reaction force receiving mechanism 30 is configured to generate a thrust force to cancel out (reduce) a reaction force generated by driving the X stage 2.

The controller 50 is configured to control the generation of the thrust force in the reaction force receiving mechanism 30.

A specific structure of the reaction force receiving mechanism 30 and a specific control of the controller 50 are described later.

As shown in FIG. 1A, the vibration isolation bases 8 are arranged at three positions on the base frame 6 which can be an installation reference, and the platen 5 serving as a traveling surface for the Y stage 1 is arranged on the vibration isolation bases 8 in the stage apparatus 100 according to the present embodiment.

Then, the Y stage 1 is arranged so as to be reciprocally movable in the Y direction on the platen 5, and the X stage 2 is arranged so as to be reciprocally movable in the X direction on the Y stage 1.

Specifically, the Y linear motors 10 are provided on both sides in the X direction of a central portion of the platen 5, and the Y stage 1 is arranged on the Y linear motor movable element 10a of each Y linear motor 10.

Further, the X stage 2 is arranged on the X linear motor movable element 1a of the X linear motor 20.

The reaction force receiving mechanism 30 includes a reaction force receiving mechanism movable element 30a (a third movable element) and a reaction force receiving mechanism stator 30b (a third stator), and the reaction force receiving mechanism movable element 30a is fixed to the Y linear motor movable element 10a coupled to one Y stage 1.

That is, the reaction force receiving mechanism movable element 30a moves in the Y direction in accordance with the movement in the Y direction of the Y linear motor movable element 10a.

On the other hand, the reaction force receiving mechanism stator 30b is a long frame body extending in the Y direction with a similar length as the Y linear motor stator 10b, and is fixed to the base frame 6.

Thereby, the reaction force receiving mechanism stator 30b can generate a predetermined thrust force in the X direction in the reaction force receiving mechanism movable element 30a regardless of the position in the Y direction of the reaction force receiving mechanism movable element 30a.

As described above, since the reaction force receiving mechanism movable element 30a operates in conjunction with the Y linear motor movable element 10a, the reaction force generated by driving the X stage 2 can be canceled out regardless of the position in the Y direction of the X stage 2.

Thereby, an accuracy of canceling out the reaction force can be maintained regardless of the position in the Y direction of the X stage 2.

Further, since the reaction force receiving mechanism 30 is configured not to apply an unnecessary force to the platen 5, it is possible to suppress a transient deformation of the platen 5 due to the operation of the reaction force receiving mechanism 30.

Thereby, the Y stage 1 and the X stage 2 can be operated precisely and accurately with respect to the platen 5 as a position reference in the stage apparatus 100 according to the present embodiment.

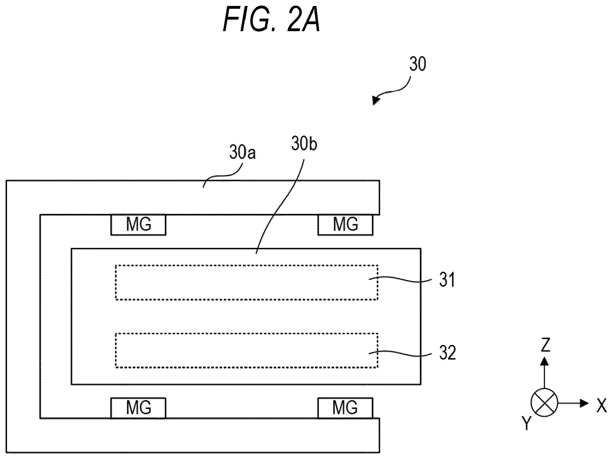

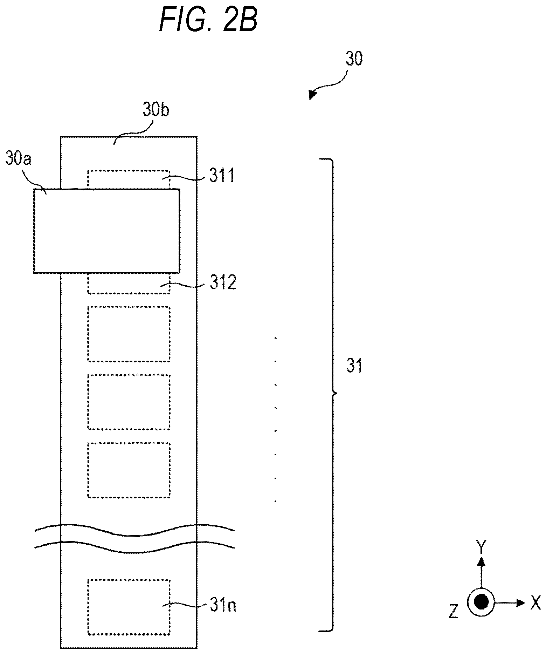

FIGS. 2A and 2B show a schematic sectional view and a schematic top view of the reaction force receiving mechanism 30 provided in the stage apparatus 100 according to the present embodiment, respectively.

As shown in FIG. 2A, four permanent magnets MG are provided apart from each other in each of the X-direction and the Z-direction on an inner surface of the reaction force receiving mechanism movable element 30a facing the reaction force receiving mechanism stator 30b.

That is, two permanent magnet pairs each including two permanent magnets MG arranged apart from each other in the X direction are arranged apart from each other in the Z direction on the inner surface of the reaction force receiving mechanism movable element 30a facing the reaction force receiving mechanism stator 30b.

On the other hand, two layers of coil groups of a first coil group 31 and a second coil group 32 arranged apart from each other in the Z direction are provided inside the reaction force receiving mechanism stator 30b.

The present invention is not limited to this, and three or more layers of coil groups arrayed in the Z direction may be provided inside the reaction force receiving mechanism stator 30b.

Further, each coil group includes a plurality of coils such that the first coil group 31 includes the plurality of coils 311, 312, ..., and 31n arrayed away from each other in the Y direction as shown in FIG. 2B, for example.

That is, coils (electromagnets) are provided at a plurality of positions in each of the Y direction and the Z direction inside the reaction force receiving mechanism stator 30b.

As described above, the reaction force receiving mechanism 30 has a structure of a voice coil motor.

Then, the controller 50 can adjust an orientation and a magnitude of a current supplied to each coil of the reaction force receiving mechanism 30 to make the thrust forces generated by respective coils different from each other.

In the stage apparatus 100 according to the present embodiment, since the coils generate different thrust forces in the reaction force receiving mechanism 30, it is possible to generate thrust forces in a plurality of action axes when the reaction force generated by driving the X stage 2 is canceled out.

In other words, a plurality of thrust force generating units capable of generating thrust forces of different magnitudes are provided at a plurality of positions in each of the Y direction and the Z direction in the reaction force receiving mechanism 30 provided in the stage apparatus 100 according to the present embodiment.

For example, a case is considered in which a position where a reaction force is generated in the reaction force receiving mechanism 30 by driving the X stage 2 and a position where a thrust force for canceling out the reaction force is generated by the reaction force receiving mechanism 30 are different from each other in the Z direction.

In other words, a case is considered in which a position at which a thrust force for moving the X stage 2 is generated by the X linear motor 20 and a position at which a thrust force for canceling out a reaction force is generated by the reaction force receiving mechanism 30 are different from each other in the Z direction.

In still other words, a case is considered in which an action axis of a reaction force generated by a movement of the X stage 2 and an action axis of a thrust force generated by the reaction force receiving mechanism 30 are shifted in the Z direction.

At this time, a couple of a pitching (ωY) corresponding to a rotation around the Y direction is generated.

In this case, such couple of the pitching (ωY) can be canceled out by setting a difference between thrust forces generated by the first coil group 31 and the second coil group 32 in the stage apparatus 100 according to the present embodiment.

Further, a case is considered in which a position where a reaction force is generated in the reaction force receiving mechanism 30 by driving the X stage 2 and a position where a thrust force for canceling out the reaction force is generated by the reaction force receiving mechanism 30 are different from each other in the Y direction.

In other words, a case is considered in which a position at which a thrust force for moving the X stage 2 is generated by the X linear motor 20 and a position at which a thrust force for canceling out a reaction force is generated by the reaction force receiving mechanism 30 are different from each other in the Y direction.

In still other words, a case is considered in which an action axis of a reaction force generated by a movement of the X stage 2 and an action axis of a thrust force generated by the reaction force receiving mechanism 30 are shifted in the Y direction.

At this time, a couple of a yawing (ωZ) corresponding to a rotation around the Z direction is generated.

In this case, a plurality of coils are selected (determined) in each of the first coil group 31 and the second coil group 32 based on a position in the Y direction of the Y stage 1, namely the X stage 2 measured by the measuring unit 60 in the stage apparatus 100 according to the present embodiment.

Then, such couple of the yawing (ωZ) can be canceled out by setting a difference between thrust forces generated by the plurality of selected coils.

As described above, a plurality of thrust force action axes that are not on the same action line are provided by a plurality of coils, and the thrust force is set independently in the plurality of thrust force action axes in the stage apparatus 100 according to the present embodiment.

It becomes possible to control the thrust force action axis for canceling out the reaction force by a total force of the plurality of thrust forces set in this way.

With respect to a thrust force generated by each coil included in the first coil group 31 and the second coil group 32 provided in the stage apparatus 100 according to the present embodiment, namely a magnitude of a current supplied to each coil, two stage gain parameters (gain blocks) are implemented.

Specifically, a first stage gain parameter is a gain parameter (a second gain parameter) common to all coils.

The gain parameter is adjusted such that a disturbance variation amount in the X direction in a predetermined object, which is generated when the X stage 2 is driven, namely when the reaction force generated by the generation of the thrust force of the X linear motor 20 is reduced, is minimized.

The disturbance variation in the predetermined object is a vibration of the platen 5, for example.

Further, a second stage gain parameter is a gain parameter (a first gain parameter) for a thrust force difference between the coils.

The gain parameter for the thrust force difference is adjusted such that the disturbance variation amount in the Y direction and the Z direction other than the X direction in the predetermined object, which is generated when the X stage 2 is driven, namely when the reaction force generated by the generation of the thrust force of the X linear motor 20 is reduced, is minimized.

Note that the above-described predetermined object includes at least one of the Y stage 1, the X stage 2, the fine movement top plate 25 and the platen 5, and is set based on the disturbance variation amount in each of them.

Further, the gain parameter for the thrust force difference as the second stage gain parameter may be calculated from the disturbance variation amount obtained at a single position in a movable range of each stage, or may be calculated from the disturbance variation amounts obtained at a plurality of positions therein.

Furthermore, the gain parameter for the thrust force difference may be a constant, a function with respect to a position of each stage, or may be sequentially switched between a plurality of ranges set according to the position of each stage, namely a table.

In addition, the gain parameter for the thrust force difference may be configured in a feedforward block in a control system of reaction force receiving mechanism 30 and in a feedback block of any of Y stage 1, X stage 2, the fine movement top plate 25 and the platen 5.

In other words, the reaction force receiving mechanism 30 may be feedforward-controlled, and may also be feedback-controlled in accordance with changes in the Y stage 1, the X stage 2, the fine movement top plate 25 and the platen 5.

In this case, it is possible to suppress an influence on the gain parameter due to a change of a direction in which the thrust force for canceling out the reaction force acts after the gain parameter is adjusted.

The two stage gain parameters adjusted when the stage apparatus 100 according to the present embodiment is assembled are described above.

In addition, it is preferred to provide a third stage gain parameter (a third gain parameter) for switching a parameter in accordance with a usage state or an operation sequence of a pattern forming apparatus such as an exposure apparatus on which the stage apparatus 100 according to the present embodiment is mounted.

When the pattern forming apparatus on which the stage apparatus 100 according to the present embodiment is mounted is operated, a center of gravity and a driving force of each stage change in accordance with the operation sequence (an operation profile) of each stage, a type of the substrate W mounted on the X stage 2 and the like.

Accordingly, the third stage gain parameter is an optimum parameter calculated in advance in accordance with various states different from the state when the stage apparatus 100 according to the present embodiment is adjusted.

Specifically, the controller 50 receives information about the state of the stage apparatus 100 according to the present embodiment from a higher system which manages the state, the usage environment and the operation sequence of the pattern forming apparatus on which the stage apparatus 100 according to the present embodiment is mounted.

Then, the controller 50 performs an operation of switching the third stage gain parameter as necessary based on the received information.

Thereby, even if the stage apparatus 100 according to the present embodiment is in various states in accordance with the state and the operation sequence of the pattern forming apparatus on which the stage apparatus 100 according to the present embodiment is mounted, the reaction force can be canceled out with a high accuracy.

The third stage gain parameter may be a gain parameter common to all coils included in the first coil group 31 and the second coil group 32, a gain parameter for a thrust force difference between the coils, or both of the gain parameters.

Further, the first stage gain parameter, the second stage gain parameter and the third stage gain parameter described above may be updated in accordance with a change over time such as an increase in friction in each driving unit in the stage apparatus 100 according to the present embodiment, or may be periodically updated.

As described above, the stage apparatus 100 according to the present embodiment is provided with the reaction force receiving mechanism 30 configured to be able to generate the thrust forces having different magnitudes at a plurality of positions in each of the Y direction and the Z direction in order to cancel out the reaction force generated by driving the X stage 2 in the X direction.

Thereby, it is possible to suppress a generation of a couple without adjusting positions of an action axis of the reaction force and an action axis of the thrust force.

In the stage apparatus 100 according to the present embodiment, a so-called moving magnet structure is employed in which permanent magnets are provided in the Y linear motor movable element 10a of the Y linear motor 10, whereas a coil array is provided in the Y linear motor stator 10b of the Y linear motor 10, but the present invention is not limited to this.

That is, a so-called moving coil structure may be employed in which the coil array is provided in the Y linear motor movable element 10a of the Y linear motor 10, whereas the permanent magnets are provided in the Y linear motor stator 10b of the Y linear motor 10.

Similarly, the moving coil structure may be employed in the X linear motor 20.

Further, in the stage apparatus 100 according to the present embodiment, the reaction force receiving mechanism 30 is provided on one side in the X direction of the X stage 2 as shown in FIGS. 1A and 1B, but the present invention is not limited to this, namely the reaction force receiving mechanism 30 may be provided on both sides in the X direction of the X stage 2.

In this case, the magnitude of the thrust force generated by each reaction force receiving mechanism 30 in order to cancel out the reaction force generated by driving the X stage 2 can be reduced.

Thereby, it is possible to suppress a heat generation, a mechanical deformation, and an occurrence of a disturbance in the Y direction and the Z direction due to the generation of the thrust force in each reaction force receiving mechanism 30, for example.

### [Second Embodiment]

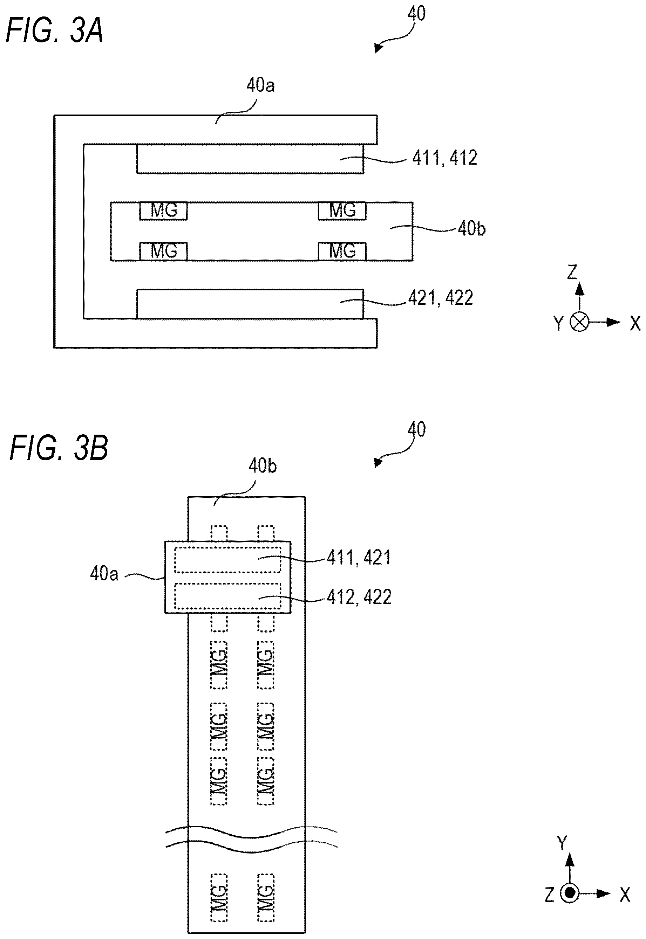

FIGS. 3A and 3B show a schematic sectional view and a schematic top view of a reaction force receiving mechanism 40 provided in a stage apparatus according to a second embodiment of the present invention, respectively.

The stage apparatus according to the present embodiment has the same structure as the stage apparatus 100 according to the first embodiment, except that the reaction force receiving mechanism 40 is provided instead of the reaction force receiving mechanism 30, so that the same members are denoted by the same reference numerals, and description thereof is omitted.

As shown in FIGS. 3A and 3B, the reaction force receiving mechanism 40 is formed by a reaction force receiving mechanism movable element 40a and a reaction force receiving mechanism stator 40b.

Then, four coils 411, 412, 421 and 422 are arranged apart from each other in the Y direction and the Z direction on an inner surface of the reaction force receiving mechanism movable element 40a facing the reaction force receiving mechanism stator 40b.

Note that the present invention is not limited to this, and the coils may be provided at three or more positions in the Y direction on the inner surface of the reaction force receiving mechanism movable element 40a facing the reaction force receiving mechanism stator 40b.

On the other hand, a plurality of groups of four permanent magnets MG arranged apart from each other in each of the X direction and the Z direction are arrayed apart from each other in the Y direction inside the reaction force receiving mechanism stator 40b.

That is, two permanent magnet pairs each including two permanent magnets MG arranged apart from each other in the X direction are provided apart from each other in the Z direction, and the plurality of permanent magnet pairs are arrayed apart from each other in the Y direction inside the reaction force receiving mechanism stator 40b.

Thereby, positions in the Z direction of thrust forces generated by the coils 411 and 412 are the same as each other, and positions in the Z direction of thrust forces generated by the coils 421 and 422 are the same as each other.

Further, positions in the Y direction of the thrust forces generated by the coils 411 and 421 are the same as each other, and positions in the Y direction of the thrust forces generated by the coils 412 and 422 are the same as each other.

Then, the controller 50 can adjust an orientation and a magnitude of a current supplied to each of the coils 411, 412, 421 and 422 to make the thrust force generated by each coil different from each other.

In the stage apparatus according to the present embodiment, since the coils generate such different thrust forces in the reaction force receiving mechanism 40, it becomes possible to generate the thrust forces of a plurality of action axes when canceling out the reaction force generated by driving the X stage 2.

For example, a case is considered in which a position at which the reaction force generated by driving the X stage 2 acts on the reaction force receiving mechanism 40 and a position at which a thrust force for canceling out the reaction force is generated by the reaction force receiving mechanism 40 are different from each other in the Z direction.

At this time, a couple of a pitching (ωY) corresponding to the rotation around the Y direction is generated.

In this case, it is possible to cancel out such couple of the pitching (ωY) by setting a thrust force difference between the coil 411 and the coil 421 and setting a thrust force difference between the coil 412 and the coil 422 in the stage apparatus according to the present embodiment.

Further, a case is considered in which a position at which the reaction force generated by driving the X stage 2 acts on the reaction force receiving mechanism 40 and a position at which the thrust force for canceling out the reaction force is generated by the reaction force receiving mechanism 40 are different from each other in the Y direction.

At this time, a couple of a yawing (ωZ) corresponding to the rotation around the Z direction is generated.

In this case, it is possible to cancel out such couple of the yawing (ωZ) by setting a thrust force difference between the coil 411 and the coil 412 and setting a thrust force difference between the coil 421 and the coil 422 in the stage apparatus according to the present embodiment.

The gain parameters for the thrust force generated by each of the coils 411, 412, 421 and 422 provided in the stage apparatus according to the present embodiment, namely the magnitude of the current supplied to each coil, can be set in the same manner as in the stage apparatus 100 according to the first embodiment.

As described above, the stage apparatus according to the present embodiment is provided with the reaction force receiving mechanism 40 configured to be able to generate the thrust forces having different magnitudes at a plurality of positions in each of the Y direction and the Z direction in order to cancel out the reaction force generated by driving the X stage 2 in the X direction.

Thereby, it is possible to suppress a generation of a couple without adjusting positions of an action axis of the reaction force and an action axis of the thrust force.

Although the preferred embodiments have been described above, the present invention is not limited to these embodiments, and various modifications and changes can be made within the scope of the gist of the present invention.

According to the present invention, a stage apparatus capable of reducing the reaction force generated when a stage is moved with suppressing the generation of the couple, can be provided.

### [Exposure apparatus]

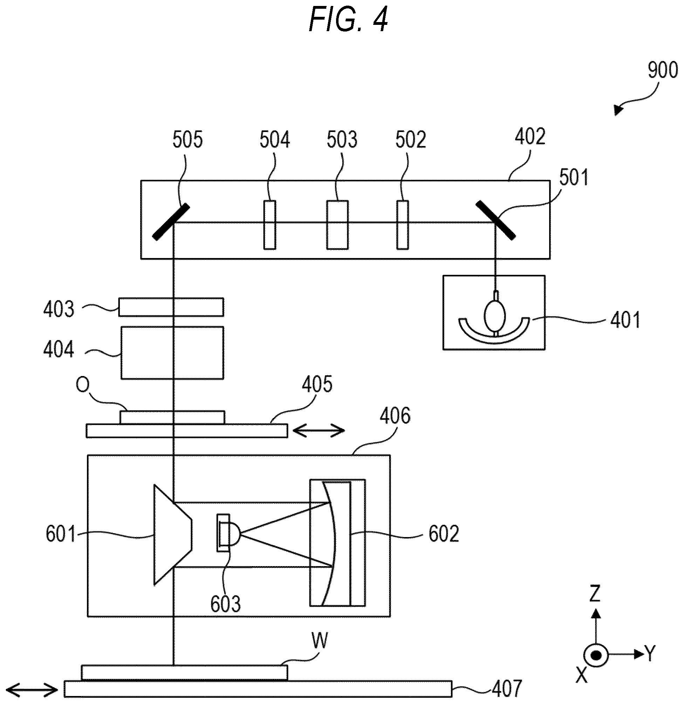

FIG. 4 shows a schematic sectional view of an exposure apparatus 900 provided with the stage apparatus according to the first embodiment or the second embodiment.

The exposure apparatus 900 includes a lamp lighting device 401 (a light source), an illuminating optical system 402, a slit 403, an imaging optical system 404, an original stage 405, a projecting optical system 406 and a substrate stage 407.

Note that the stage apparatus according to the present invention is used to control driving of the substrate stage 407, for example.

The lamp lighting device 401 is a light source for emitting ultraviolet light, such as a high-pressure mercury lamp.

The illuminating optical system 402 includes a first bending mirror 501, a first condensing lens 502, a fly-eye lens 503, a second condensing lens 504 and a second bending mirror 505.

The original stage 405 is a mask stage for holding the original O, and can be driven in the Y direction shown in FIG. 4.

The projecting optical system 406 is a projecting optical system for projecting to transfer a pattern drawn on the original O onto the substrate W coated with a photoresist.

Note that the exposure apparatus 900 uses a projecting optical system 406 of an Offner type optical system.

In the case of the Offner type optical system, the original O is irradiated in an arc shape in order to secure a favorable image region. Further, an irradiation shape of exposure light reaching the substrate W is also an arc shape.

The light passing through the original O is reflected by a trapezoidal mirror 601, a concave surface mirror 602, a convex surface mirror 603, the concave surface mirror 602 and the trapezoidal mirror 601 in this order to reach the substrate W, thereby the pattern on the original O is transferred onto the substrate W.

The substrate stage 407 is a wafer stage for holding the substrate W, and is driven in the Y direction in synchronization with the original stage 405 to expose the substrate W. The substrate stage 407 can be driven in the X direction in addition to the Y direction, and in the case of forming a plurality of panels on the substrate W, exposure is performed by driving the substrate stage 407 in the X direction and the Y direction.

The exposure light emitted from the lamp lighting device 401 passes through the illuminating optical system 402, the slit 403 and the imaging optical system 404, and then irradiates the original O mounted on the original stage 405.

Then, the exposure light passing through the original O passes through the projecting optical system 406 and irradiates the substrate W mounted on the substrate stage 407 to expose an exposure region on the substrate W.

Although the embodiment in which the stage apparatus according to the present invention is provided in the exposure apparatus 900 has been described above, the present invention is not limited to this, and the stage apparatus according to the present invention can also be applied to a pattern forming apparatus such as an imprint apparatus or a drawing apparatus.

Further, the stage apparatus according to the present invention can also be applied to a substrate processing apparatus such as a coating and developing apparatus that performs coating and developing of a photoresist on the substrate W.

The imprint apparatus referred to herein is an apparatus for forming a pattern of a cured product to which a pattern of the mold material is transferred by bringing an imprint material supplied onto a substrate and a mold material into contact with each other and then applying curing energy to the imprint material.

Further, the drawing apparatus is an apparatus for forming a pattern (a latent image pattern) on the substrate by drawing on the substrate with a charged particle beam (an electron beam) or a laser beam.

### [Method for manufacturing an article]

A method for manufacturing an article according to the present invention is suitable for manufacturing an article such as a microdevice including a semiconductor device or an element with a microstructure.

The method for manufacturing an article according to the present invention includes a step of forming a latent image pattern on a photoresist applied to a substrate by using the exposure apparatus 900 described above (an exposure step of exposing the substrate).

Further, the method for manufacturing an article according to the present invention includes a developing step (a processing step) of developing the substrate on which the latent image pattern is formed in the exposure step.

Furthermore, the method for manufacturing an article according to the present invention includes other known manufacturing steps (oxidation, film formation, vapor deposition, doping, planarization, etching, photoresist peeling, dicing, bonding, packaging and the like) performed on the substrate developed in the developing step.

The method for manufacturing an article according to the present invention is advantageous in at least one of performance, quality, productivity and production cost of the article as compared to a conventional method.

Further, the method for manufacturing an article according to the present invention is not limited to the exposure apparatus 900 described above, and may be performed by using a pattern forming apparatus such as an imprint apparatus or a drawing apparatus including the stage apparatus according to the present invention.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A stage apparatus comprising:
a first stage configured to be movable in a first direction;
a first driving unit configured to generate a thrust force to move the first stage in the first direction; and
a reaction force reducing unit configured to generate a thrust force to reduce a reaction force generated by the generation of the thrust force of the first driving unit,
wherein the reaction force reducing unit is configured to be capable of generating the thrust forces with different magnitudes from each other at a plurality of positions in a second direction perpendicular to the first direction, and to be capable of generating the thrust forces with different magnitudes from each other at a plurality of positions in a third direction perpendicular to the first direction and the second direction.

2. The stage apparatus according to claim 1, further comprising:
a measuring unit configured to measure a position of the first stage; and
a controller configured to control the reaction force reducing unit,
wherein the reaction force reducing unit includes a plurality of thrust force generating units each of which is arranged at the respective positions, and
wherein the controller is configured to determine at least one thrust force generating unit generating the thrust force to reduce the reaction force based on the position in the second direction of the first stage measured by the measuring unit.

3. The stage apparatus according to claim 2, wherein the controller has a first gain parameter for determining the magnitude of the thrust force generated by each of the determined at least one thrust force generating unit.

4. The stage apparatus according to claim 3, wherein the controller is configured to:
cause the first driving unit to generate the thrust force to move the first stage in the first direction at each of at least one position in the second direction; and
calculate the first gain parameter by determining the magnitude of each thrust force generated by the plurality of thrust force generating units so as to minimize a disturbance variation amount in the second direction generated when reducing the reaction force due to the generation of the thrust force of the first driving unit.

5. The stage apparatus according to claim 4, wherein the first gain parameter is represented by a function with respect to a position in the second direction.

6. The stage apparatus according to claim 4, wherein the first gain parameter is represented by a table with respect to a position in the second direction.

7. The stage apparatus according to any one of claims 4 to 6, wherein the controller is configured to update the first gain parameter by periodically recalculating the first gain parameter.

8. The stage apparatus according to any one of claims 2 to 7, wherein the controller has a second gain parameter common to the plurality of thrust force generating units, and a third gain parameter changing in accordance with a usage state or an operation sequence of the stage apparatus.

9. The stage apparatus according to any one of claims 2 to 8, wherein the controller is configured to perform a feedforward control on the determined at least one thrust force generating unit to cause the determined at least one thrust force generating unit to generate the thrust force.

10. The stage apparatus according to any one of claims 1 to 9, further comprising:
a second stage configured to be movable in the second direction; and
a second driving unit configured to generate a thrust force to move the second stage in the second direction,
wherein the first driving unit includes a first stator extending in the first direction, and a first movable element fixed to the first stage and movable in the first direction,
wherein the second driving unit includes a second stator extending in the second direction, and a second movable element fixed to the second stage and movable in the second direction, and
wherein the first stator and the second movable element are coupled to each other.

11. The stage apparatus according to claim 10, wherein the reaction force reducing unit includes a third stator extending in the second direction, and a third movable element fixed to the second movable element and movable in the second direction.

12. The stage apparatus according to claim 11, wherein the reaction force reducing unit is a voice coil motor including a plurality of electromagnets each of which is arranged at respective positions in the second direction of the third stator, and at least one permanent magnet pair fixed to the third movable element.

13. The stage apparatus according to claim 11, wherein the reaction force reducing unit is a voice coil motor including a plurality of permanent magnet pairs each of which is arranged at respective positions in the second direction of the third stator, and a plurality of electromagnets each of which is arranged at respective positions in the second direction of the third movable element.

14. The stage apparatus according to any one of claims 1 to 13, wherein the reaction force reducing unit is provided on both sides in the first direction of the first stage.

15. A pattern forming apparatus for forming a pattern on a substrate, comprising the stage apparatus according to any one of claims 1 to 14 configured to control driving of the first stage on which the substrate is mounted.

16. A method for manufacturing an article, comprising:
forming a pattern on the substrate by using the pattern forming apparatus according to claim 15; and
processing the substrate on which the pattern is formed to obtain the article.

17. A method for controlling a reaction force reducing unit in a stage apparatus including a first stage configured to be movable in a first direction, a first driving unit configured to generate a thrust force to move the first stage in the first direction, and the reaction force reducing unit configured to generate a thrust force to reduce a reaction force generated by the generation of the thrust force of the first driving unit, the reaction force reducing unit being configured to be capable of generating the thrust forces with different magnitudes from each other at a plurality of positions in a second direction perpendicular to the first direction, and to be capable of generating the thrust forces with different magnitudes from each other at a plurality of positions in a third direction perpendicular to the first direction and the second direction, comprising:
measuring a position of the first stage; and
determining the magnitude of the thrust force generated at each of the plurality of positions in the second direction of the reaction force reducing unit based on the position in the second direction of the first stage measured in the measuring step and a gain parameter.
